# EUROPEAN PATENT APPLICATION

(11) **EP 2 515 333 A2**
(43) Date of publication of application: **24.10.2012**
(21) Application number: 12162585.9
(22) Date of filing: 30.03.2012
(51) Int. Cl.: H01L 25/075, H01L 33/50, H01L 33/54

(54) **Light Emitting Device Module and Method of Manufacturing the Same**

(30) Priority: 21.04.2011 KR 20110037215
(71) Applicant: Samsung LED Co., Ltd., Yongi-city, Gyeonggi-Do 446-711 (KR)
(72) Inventor: Kim, Hak Hwan, 443-706 Gyeonggi-do (KR); Moon, Kyung Mi, 443-743 Gyeonggi-do (KR); Paek, Ho Sun, 443-751 Gyeonggi-do (KR); Song, Young Hee, 463-863 Gyeonggi-do (KR)
(74) Representative: Grünecker, Kinkeldey, Stockmair & Schwanhäusser

(57) **Abstract**

A light emitting device (LED) module, and manufacturing method of the same, which may be applied to various applications is provided. The LED module may be miniaturized by directly mounting an LED and a lens unit on a substrate, and price competitiveness may be enhanced by lowering a fraction defective and increasing yield of the LED module. In a method of manufacturing an LED module, an operation may be minimized and simplified by directly mounting LEDs and a plurality of lens units having various shapes, collectively forming the plurality of lens units, and by performing the operation on a wafer level. A heat radiation characteristic may be enhanced through use of a metallic material as a substrate and a bump.

## Description

### CROSS-REFERENCE TO RELATED APPLICATIONS

This application claims the benefit under 35 U.S.C. § 119(a) of Korean Patent Application No. 10-2011-0037215, filed on April 21, 2011, in the Korean Intellectual Property Office, the entire disclosure of which is incorporated herein by reference for all purposes.

### BACKGROUND

### 1. Field

The following description relates to light emitting device (LED) module and a manufacturing method thereof, and more particularly, to an LED module having a desired orientation angle, an enhanced heat radiation characteristic, and color uniformity, and a simplified manufacturing method.

### 2. Description of Related Art

A light emitting device (LED) is a semi-conductor light emitting apparatus that emits light when a current flows. The LED may have features of a long life-span, a low power consumption, a fast response speed, an excellent initial operation, and the like and thus, may be widely applied to a lighting device, a headlight and a courtesy light of a car, an electronic display board, a backlight of a display device, and the like. The number of fields that adapt the LED has increased.

Recently, the LED is used as a light source of various colors. As the demand for a high power and high luminance LEDs, such as a white LED for lighting and the like, increases, research for improving the performance and reliability of an LED package has been actively conducted. To improve the performance of an LED product, an LED package that effectively extracts light, that has an excellent color purity, and that has a uniform property among products may be needed in addition to an LED with an excellent optical efficiency.

Phosphors may be arranged on a blue LED or an ultraviolet LED to obtain a white light using the LED. The white LED may color-transform a portion of light extracted from the blue LED or the ultraviolet LED, based on a combination of a red phosphor, a green phosphor, a blue phosphor, and a yellow phosphor, and may provide a while light by mixing the phosphors. In addition to an efficiency that is the most important factor for determining the performance of the white LED, a color uniformity may also be important in terms of a color quality.

An LED may be manufactured as a package or a module to be a product. The LED package may be manufactured by first mounting an LED chip on a lead frame or a ceramic substrate, mixing and applying phosphors suitable for a desired application, and molding a lens. Thereafter, the LED package may be cut to be into unit LED packages and mounted on a printed circuit board (PCB) to be modularized.

Most structures of a high power LED package, driven at a power of at least 350 mA, may include a heat slug or have a via electrode, a metallic reflection film, and a cup formed on a ceramic base plate. In contrast, a low power LED driven at a power of at least 200 mA may generally employ an LED package in a lead frame form.

A structure that mounts the LED package on a PCB to be modularized may have a limit to miniaturization of an LED module, and may not decrease a manufacturing cost of the LED module due to a high rate of error during mounting. Luminance and a color of the LED package may have a deviation due to a deviation in a wavelength and luminance of an LED, a manufacturing tolerance on implement such as the lead frame, and a process tolerance on a phosphor coating process, a lens molding process, and the like.

To improve an optical uniformity of the LED module, such as the luminance and a color uniformity of the LED module, various LEDs having various amounts of luminance and colors may be binned and grouped, and each binned LED may be used in combination.

When a difference in amount of luminance and color of a separate LED is relatively significant, the difference in amount of luminance and color may stand out in the LED module even though the LEDs are binned and thus, a binning group of the LED package may be determined to be within a range in which an optical deviation of the LED module does not occur. Thus, LEDs excluded from the determined binning group may not be used, which may decrease yield and increase a cost of manufacturing the LED module.

Recently, a chip on board (COB) scheme in which an LED is directly mounted on a module substrate is used to manufacture the LED as a module rather than as a package. The LED module manufactured through the COB scheme may reduce a price incurred by a manufacture of a package, and enhance heat radiation efficiency by reducing a heat transfer path.

### SUMMARY

Embodiments of the present invention provide a light emitting device (LED) module having a desired orientation angle, an enhanced heat radiation characteristic, color uniformity, and a simplified manufacturing method.

According to an embodiment of the present invention, there is provided an LED module, including a substrate, an LED mounted on the substrate using a bump, a phosphor layer surrounding the LED, and a lens unit directly formed on the substrate and surrounding the phosphor layer.

There may be a plurality of the LEDs, a plurality of the phosphor layers, and a plurality of the lens units, and the plurality of the lens units may be of the same shape.

Each of the plurality of lens units may be provided in an oval shape.

Each of the plurality of lens units may be provided in a batwing shape having a concave central portion.

Each of the plurality of lens units may have a shape in which a height from a central portion of each of the plurality of LEDs to an outer circumference of each of the plurality of lens units is greater than a radius from the central portion to the outer circumference.

Each of the plurality of lens units may have a shape in which a radius from a central portion of each of the plurality of LEDs to an outer circumference of each of the plurality of lens units is greater than a height from the central portion to the outer circumference.

There may be a plurality of the LEDs, a plurality of the phosphor layers, and a plurality of the lens units, and the plurality of the lens units may be in different shapes.

The plurality of the lens units may have different heights from a central portion of the LED to an outer circumference of the lens unit.

The plurality of the lens units may have different radii from a central portion of the LED to an outer circumference of the lens unit.

The plurality of the lens units may have different curvatures.

The plurality of the lens units may be arranged in a rectangular or hexagonal shape.

The LED may be mounted on the substrate in a flip chip bonding or die bonding scheme.

According to an embodiment of the present invention, there is provided an LED module, including a substrate, at least one LED mounted on the substrate in a flip chip bonding using a bump, and a lens unit directly formed on the substrate, surrounding the LED, and including a phosphor material.

A shape of the lens unit may correspond to at least one of a batwing shape having a concave central portion, a shape in which a height from a central portion of the LED to an outer circumference of the lens unit is greater than a radius from the central portion of the LED to the outer circumference of the lens unit, and a shape in which a radius from the central portion of the LED to the outer circumference of the lens unit is greater than a height from the central portion of the LED to the outer circumference of the lens unit.

The substrate and the bump may include a metallic material.

According to an embodiment of the present invention, there is provided a method of manufacturing an LED module, the method including directly mounting an LED on a substrate using a bump, forming a phosphor layer to surround the LED, and directly forming a lens unit surrounding the phosphor layer on the substrate.

The LED may be directly mounted on the substrate in a flip chip bonding or die bonding scheme.

There may be a plurality of the LEDs, a plurality of the phosphor layers, and a plurality of the lens units, and the plurality of the lens units may be formed to be the same shape.

There may be a plurality of the LEDs, a plurality of the phosphor layers, and a plurality of the lens units, and the plurality of the lens units may be formed to be different shapes.

The directly forming may include disposing a mold on the substrate where the LED and the phosphor layer are formed, injecting a lens molding compound into the mold, performing a first thermal curing treatment according to the lens molding compound, separating the mold, and performing a second thermal curing treatment with respect to the lens molding compound undergoing the first thermal curing treatment, thereby forming the lens unit.

The directly forming may include disposing a mold on the substrate where the LED and the phosphor layer are formed, injecting a lens molding compound on an upper surface of the substrate and on an entire surface of the mold, performing a first thermal curing treatment according to the lens molding compound, separating the mold, performing a second thermal curing treatment according to the lens molding compound undergoing the first thermal curing treatment, and removing a portion of the lens molding compound applied to an electric connection point on the substrate, thereby forming the lens unit.

The directly forming may include disposing a mask including a hole pattern on the substrate where the LED and the phosphor layer are formed, screen printing a lens molding compound in the hole pattern, separating the mask from the substrate, and performing a thermal curing treatment according to the lens molding compound, thereby forming the lens unit.

The screen printing may be performed in a vacuum state.

The directly forming may include forming a dam around the LED on the substrate, dispensing a lens molding compound in the dam, and performing a thermal curing treatment with respect to the lens molding compound, thereby forming the lens unit.

A height from a central portion of the LED to an outer circumference of the lens unit may be determined through a control of an amount of the lens molding compound.

The directly forming may include preparing the lens unit using a molding, applying an adhesive onto the substrate to attach the prepared lens unit, and performing a thermal curing treatment with respect to the attached lens unit.

The method may further include performing an underfill operation of injecting a filler between the substrate and the LED.

An underfill operation may be performed to inject a phosphor material, that is included in the phosphor layer when the phosphor layer is formed, between the substrate and the LED.

An underfill operation may be performed to inject a lens molding compound, that is included in the lens unit when the lens unit is formed, between the substrate and the LED.

According to an embodiment of the present invention, there is provided an LED module, the method including directly mounting at least one LED on a substrate through a flip chip bonding using a bump, and directly forming a lens unit, surrounding the at least one LED and including a phosphor material, on the substrate.

The method may further include performing an underfill operation of injecting a filler between the substrate and the at least one LED.

A shape of the lens unit may correspond to at least one of a batwing shape having a concave central portion, a shape in which a height from a central portion of the LED to an outer circumference of the lens unit is greater than a radius from the central portion of the LED to the outer circumference of the lens unit, and a shape in which a radius from the central portion of the LED to the outer circumference of the lens unit is greater than a height from the central portion of the LED to the outer circumference of the lens unit.

According to an embodiment of the present invention, there is provided a method of manufacturing an LED module, the method including directly mounting at least one LED surrounded by a phosphor layer on a substrate in a flip chip bonding using a bump, and directly forming a lens unit surrounding the phosphor layer on the substrate.

The method may further include performing an underfill operation of injecting a filler between the substrate and the at least one LED.

Other features and aspects will be apparent from the following detailed description, the drawings, and the claims.

### BRIEF DESCRIPTION OF THE DRAWINGS

FIG 1 is a diagram illustrating an example of a light emitting device (LED) module according to an embodiment of the present invention.
FIGS. 2 through 8 are diagrams illustrating an example of a module where a plurality of LEDs are mounted according to another embodiment of the present invention.
FIG. 9A and FIG. 9B are diagrams illustrating an example of manufacturing an LED module according to still another embodiment of the present invention.
FIG. 10A and FIG 10B are diagrams illustrating an example of manufacturing an LED module according to yet another embodiment of the present invention.
FIG. 11 is an operational flowchart illustrating an example of manufacturing an LED module according to further another embodiment of the present invention.
FIGS. 12 through 15 are diagrams illustrating an example of a manufactured LED module according to still another embodiment of the present invention.

Throughout the drawings and the detailed description, unless otherwise described, the same drawing reference numerals will be understood to refer to the same elements, features, and structures. The relative size and depiction of these elements may be exaggerated for clarity, illustration, and convenience.

### DETAILED DESCRIPTION

Reference will now be made in detail to embodiments, examples of which are illustrated in the accompanying drawings, wherein like reference numerals refer to the like elements throughout. Embodiments are described below to explain the present disclosure by referring to the figures.

Throughout the specification, when a description is provided in relation to each of a layer, a side, a chip, and the like is formed "on" or "under" a layer, a side, a chip, and the like, the term "on" may include "directly on" and "indirectly on interposing another element therebetween," and the term "under" may include "directly under" and "indirectly under interposing another element therebetween." A standard for "on" or "under" of each element may be determined based on a corresponding drawing.

Hereinafter, a light emitting device (LED) module according to embodiments will be described with reference to drawings.

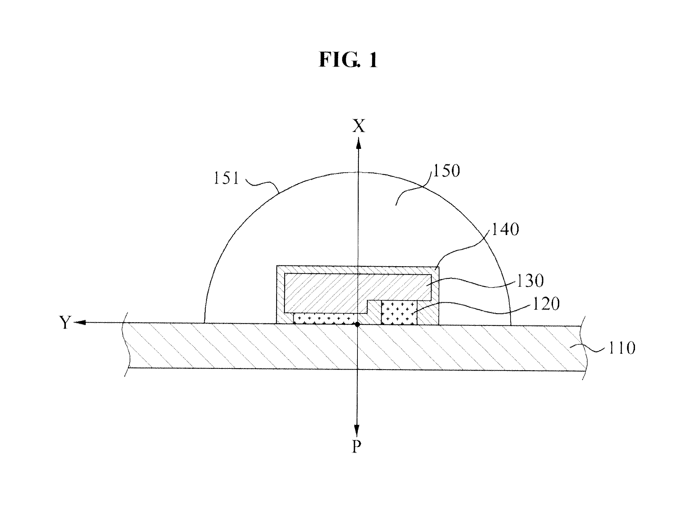

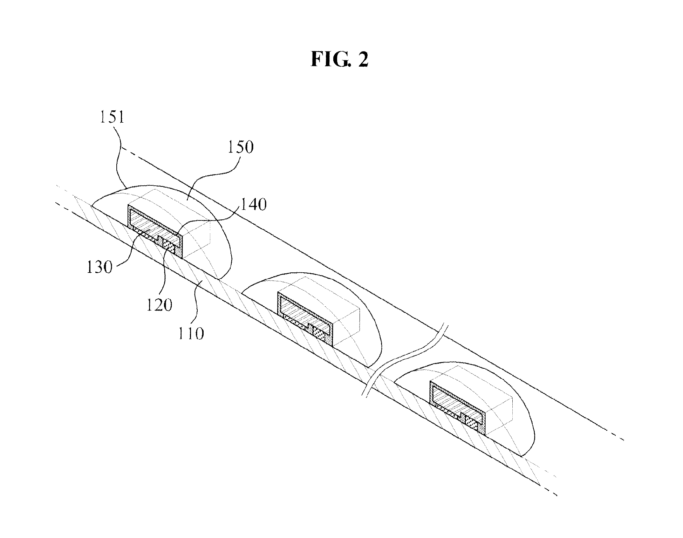

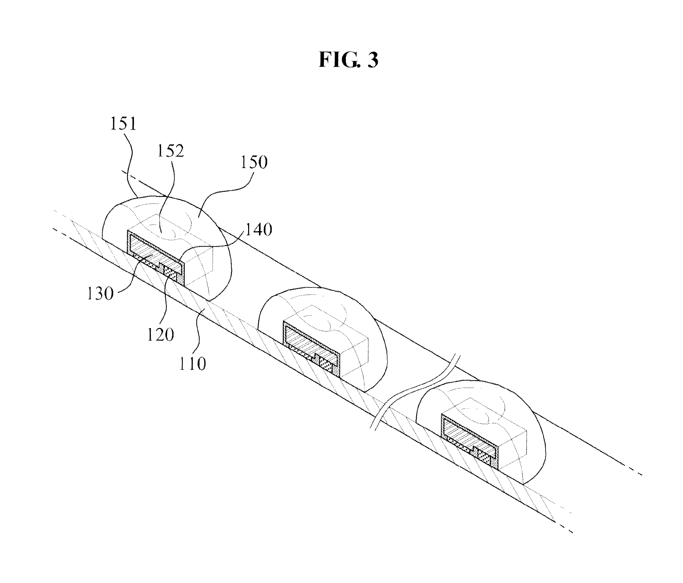

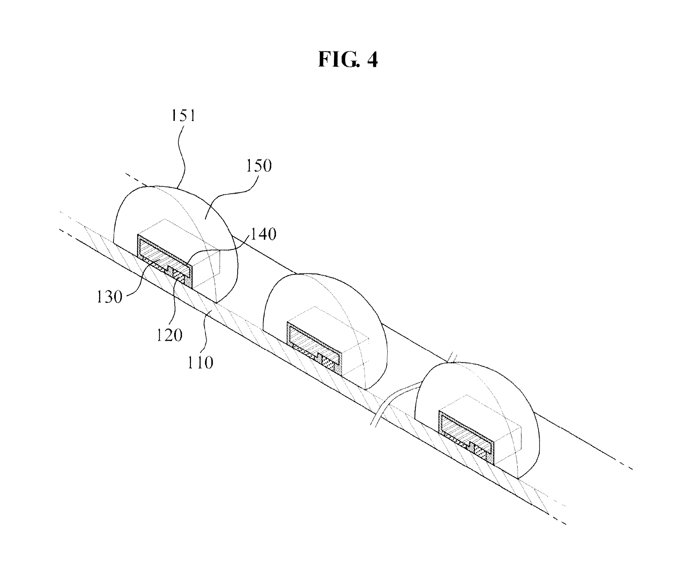

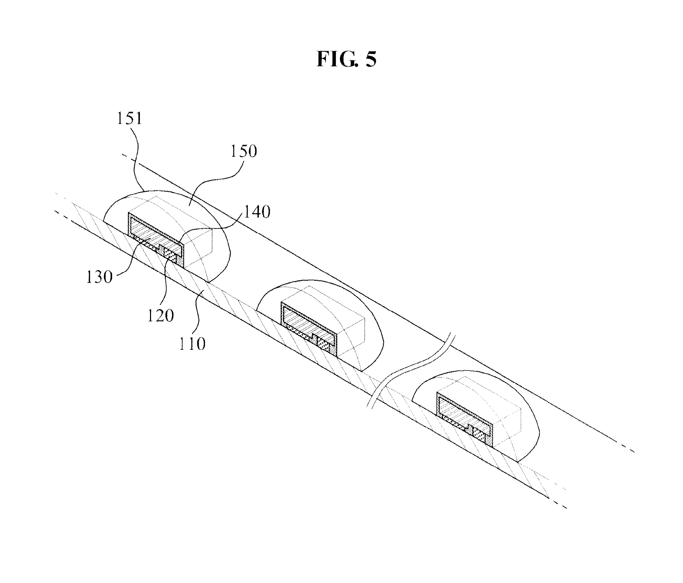

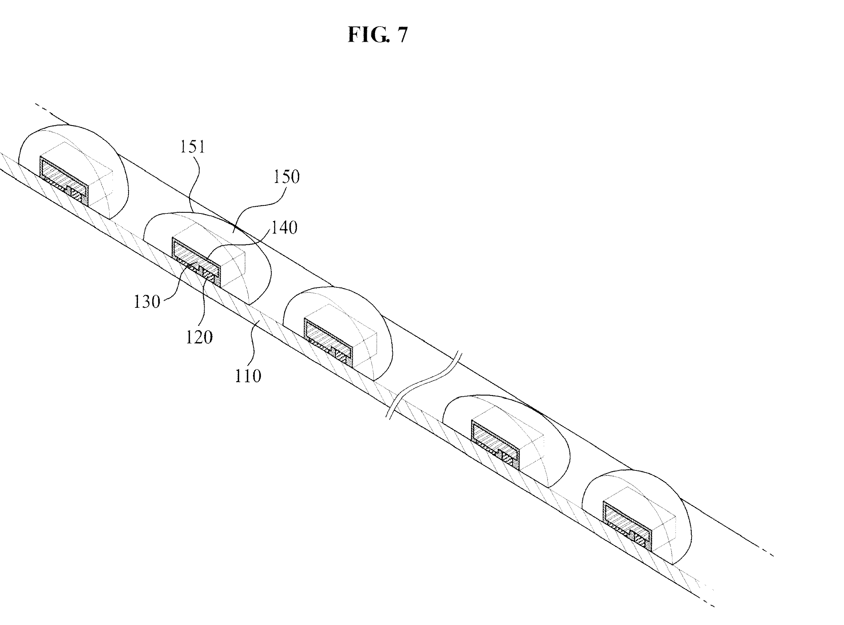

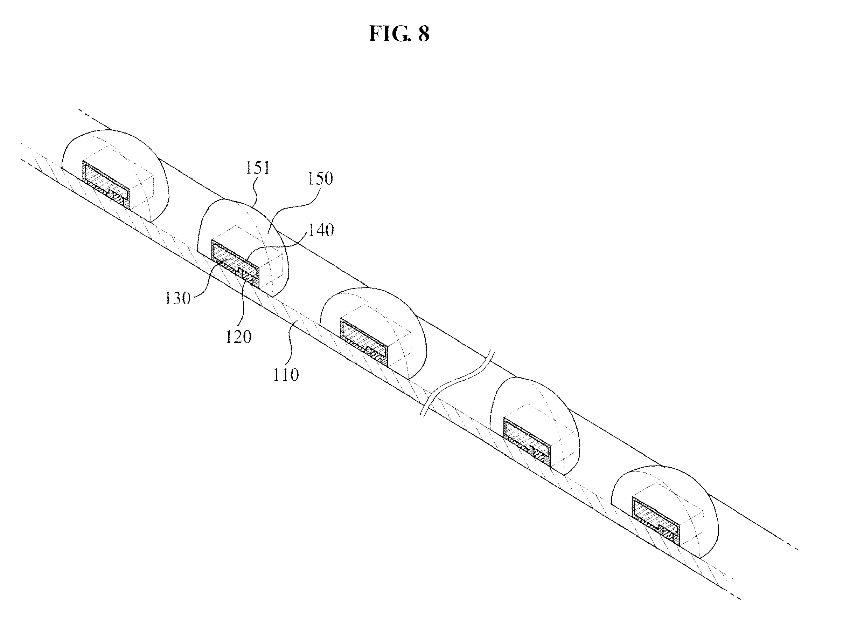

FIG. 1 illustrates an example of a light emitting device (LED) module according to an embodiment. FIGS. 2 through 8 illustrate an example of an LED module according to another embodiment.

Referring to FIGS. 1 through 8, an LED module according to an aspect of an embodiment may include a substrate 110, an LED 130 mounted on the substrate 110 using a bump 120, a phosphor layer 140 surrounding the LED 130, and a lens unit 150 directly formed on the substrate 110 and surrounding the phosphor layer 140.

The LED 130 may be mounted on the substrate 110 using the bump 120. A scheme of mounting the LED 130 may include a flip chip bonding scheme, which may use a solder or an adhesive having a conductive characteristic. That is, the LED 130 may be flip chip bonded and mounted on the substrate 110. Also, the LED 130 may be mounted on the substrate 110 by a die bonding.

According to an aspect of an embodiment, when an LED module is manufactured using a chip on board (COB) scheme, a wire bonding scheme may not be used for an electrical connection between an LED and a module substrate, rather the LED module may be implemented by a flip chip on module (FCOM) to which the LED is mounted on the module substrate in a flip chip form. That is, when the LED is mounted to the FCOM, the LED may be mounted in a flip chip form and thus, LEDs may be densely mounted on the module substrate, thereby decreasing a module size.

Here, the substrate 110 may be manufactured using metal, silicon, or ceramic. That is, the substrate 110 may be manufactured by a material having an excellent heat radiation characteristic. The bump 120 may be manufactured by a metallic material. The bump 120 may be manufactured by a material having an excellent heat radiation characteristic. As such, through manufacturing the substrate 110 and the bump 120 using materials having an excellent heat radiation characteristic, the LED module may have an enhanced heat radiation characteristic.

A filler may be disposed between the substrate 110 and the LED 130, which will be further described in reference to an underfill operation in the following.

The LED 130 may include a first conductive semiconductor layer, an active layer, a second conductive semiconductor layer, and an electrode. The first conductive semiconductor layer may comprise a group III-V compound. The first conductive semiconductor layer may comprise gallium nitride (GaN), and is not limited thereto.

The first conductive semiconductor layer may be n-doped. Here, n-doping indicates doping of a group V element, and an n-type impurity may include silicon (Si), germanium (Ge), selenium (Se), tellurium (Te), carbon (C), and the like. The first conductive semiconductor layer may comprise n-GaN. In this instance, an electron may be moved to the active layer through the first conductive semiconductor layer.

The active layer may be formed on the first conductive semiconductor layer. The active layer may be formed in a laminated structure in which a quantum barrier layer and a quantum well layer are alternately formed so that an electron and a hole may recombine and emit light. That is, the active layer may be formed in a single quantum well or multi-quantum wells. Composition of the active layer may vary depending on a desired emission wavelength. For example, the quantum barrier layer may comprise GaN, and the quantum well layer may comprise indium gallium nitride (InGaN).

The second conductive semiconductor layer may be formed on the active layer. The second conductive semiconductor layer may comprise a group III-V compound. The second conductive semiconductor layer may be p-doped. Here, p-doping indicates doping of a group III element, and a p-type impurity may include magnesium (Mg), zinc (Zn), beryllium (Be), and the like. In particular, the second conductive semiconductor layer may be doped with an Mg impurity. For example, the second conductive semiconductor layer may comprise GaN. In this instance, a hole may be moved to the active layer through the second conductive semiconductor layer.

A transparent electrode may be formed on the second conductive semiconductor layer. The transparent electrode may be formed as a transparent metal layer such as nickel (Ni) / gold (Au) or be formed to include conductive oxide such as indium tin oxide (ITO). A p-type electrode may be formed on the transparent electrode, and an n-type electrode may be formed on the first conductive semiconductor layer. Here, the p-type electrode and the n-type electrodes may comprise various conductive materials such as titanium (Ti) / aluminum (Al), and the like.

A hole may be provided through the p-type electrode, and an electron may be provided through the n-type electrode. The provided hole and the electron may combine in the active layer to generate light energy. Light may be emitted from the LED 130 including the active layer, and the LED 130 may correspond to an ultraviolet LED or a blue light LED depending on a wavelength of the emitted light.

The phosphor layer 140 may surround the LED 130. Since the phosphor layer 140 surrounds the LED 130, light emitted from the LED 130 may proceed to the lens unit 150 through the phosphor layer 140.

That is, the phosphor layer 140 may scatter and color-convert light emitted from the LED 130. For example, blue light emitted from the LED 130 may be converted to yellow, green, or red through the phosphor layer 140 and white light may be emitted to an external environment.

The phosphor layer 140 may include a phosphor material which may convert blue light to yellow, green, or red. The phosphor layer 140 may include a host material and an active material, and include, for example, a cerium (Ce) active material in an yttrium aluminum garnet (YAG) host material. An europium (Eu) active material, included in a silicate-based host material may be used for the phosphor layer 140, but may not be limited thereto.

The phosphor layer 140 may be formed to have a thin and uniform thickness. Here, phosphor particles may be uniformly distributed in the phosphor layer 140. Thus, light penetrating the phosphor layer 140 may be uniformly color-converted. By uniformly and evenly forming the phosphor layer 140, phosphor distribution around the LED 130 may be uniform, an optical design may be simplified through surface emission.

The phosphor layer 140 may be formed before the LED 130 is mounted on the substrate 110, or be formed after the LED 130 is mounted on the substrate 110. A scheme of forming the phosphor layer 140 will be further described in the following.

The lens unit 150 may be directly formed on the substrate 110 and surround the phosphor layer 140. As illustrated in FIGS. 2 through 5, a plurality of lens units 150 may be formed, and the plurality of lens units 150 may be of the same shape. An LED module according to an aspect of an embodiment may include various forms of the plurality of lens units 150 directly formed on the substrate 110 by conforming to various applications.

As an example, each of the plurality of lens units 150 may be provided in an oval shape. That is, a shape each of the plurality of lens units 150 may correspond to an ellipse in which a major axis and a minor axis differ in length. When a backlight unit employing an edge type application is used, each of the plurality of lens units 150 may be formed to be an oval shape so as to have an excellent incident rate to a light guide plate.

As another example, each of the plurality of lens units 150 may be provided in a batwing shape having a concave central portion 152. When a backlight unit or a module for flat lighting employing a direct type application is used, each of the plurality of lens units 150 may have a radiation pattern in a form of a batwing shape. In this instance, a relatively large area may be uniformly illuminated using a relatively small number of LEDs and a relatively thin LED module.

Each of the plurality of lens units 150 may have a shape in which a height from a central portion of the LED 130 to an outer circumference 151 of each of the plurality of lens units 150 is greater than a radius from the central portion of the LED 130 to the outer circumference 151. When a module is employed for a partial lighting application, it may be appropriate for each of the plurality of lens units 150 to have a radiation angle less than or equal to 60 degrees. That is, by employing each of the plurality of lens units 150 having a narrow orientation angle, light may illuminate a relatively small area.

Each of the plurality of lens units 150 may have a shape in which a radius from the central portion of the LED 130 to the outer circumference 151 of each of the plurality of lens units 150 is greater than a height from the central portion of the LED 130 to the outer circumference 151. That is, each of the plurality of lens units 150 may have a shape different from an oval shape, and have symmetric cross sections or have a longest radius that is greater than a height. When a module is employed to an L-type lamp application, it may be appropriate for each of the plurality of lens units 150 to have a radiation angle greater than or equal to 150 degrees. By employing each of the plurality of lens units 150 having a wide orientation angle, light may be uniformly illuminated in a relatively large area.

Referring to FIG. 1, P denotes the central portion of the LED 130 and indicates a location where an x-axis intersects a y-axis. That is, P indicates a location corresponding to a reference point of a height and a radius.

A height of the lens unit 150 indicates a length from the central portion P of the LED 130 to the outer circumference 151 of the lens unit 150 along the x-axis. A radius of the lens unit 150 indicates a length from the central portion P of the LED 130 to the outer circumference 151 of the lens unit 150 along the y-axis.

As described in the foregoing, shapes of each of the plurality of lens units 150 may vary according to various applications, and the shapes may include a hemisphere, and the like in addition to the aforementioned shapes.

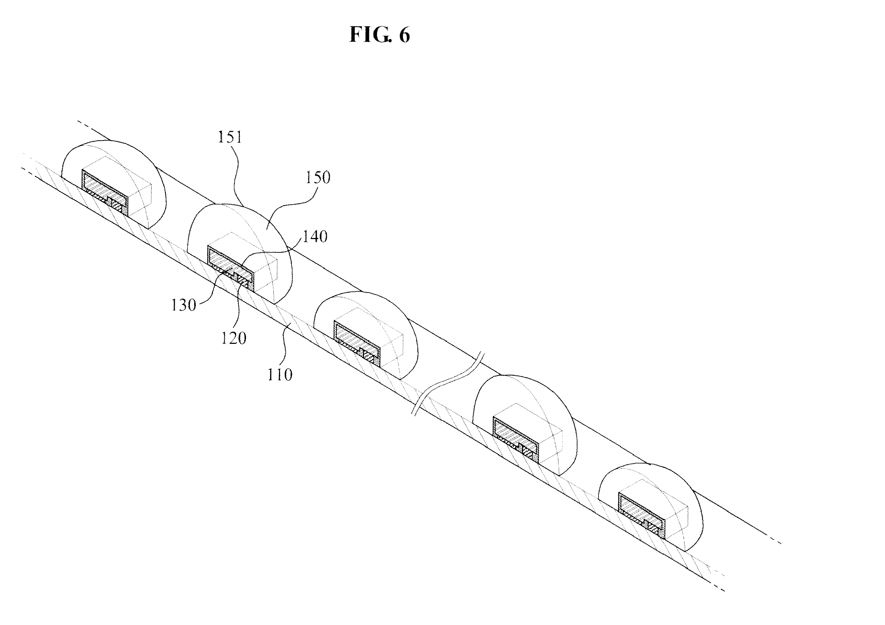

Referring to FIGS. 6 through 8, an LED module according to an aspect may include a plurality of lens units, and the plurality of lens units may be in different shapes. That is, when LEDs having various amounts of luminance and colors are binned and grouped, deviation in luminance and color of the LEDs may be significant. However, the LED module according to an aspect of an embodiment may include the plurality of lens units in different shapes, thereby achieving uniformity.

In order to achieving uniformity, the plurality of the lens units may have different heights from a central portion of an LED 130 to an outer circumference 151 of a lens unit 150. The plurality of the lens units may have different radii from the central portion of the LED 130 to the outer circumference 151 of the lens unit 150. That is, the plurality of the lens units may have different curvatures.

The plurality of the lens units may be arranged in various shapes. For example, the plurality of the lens units may be arranged in a rectangular or hexagonal shape, but may not be limited thereto. That is, the plurality of the lens units may be arranged in various shapes to reduce a deviation in luminance and color and to enhance uniformity.

Thus, the LED module according to an aspect may be applied to various applications by directly mounting an LED on a substrate and by directly mounting lens units having various shapes on the substrate.

By directly mounting the LED and the lens unit on the substrate, the LED module may be miniaturized and price competitiveness may be enhanced through a lowered fraction defective and an enhanced yield. Further, by employing lens units having various shapes, a desired orientation angle may be obtained and uniformity in luminance and color may be enhanced due to different levels of light extraction.

An LED module according to an aspect may include a substrate l l0, at least one LED 130 mounted on the substrate 110 by a flip chip bonding using a bump 120, and a lens unit 150 directed mounted on the substrate 110, surrounding the at least one LED 130, and having a phosphor material.

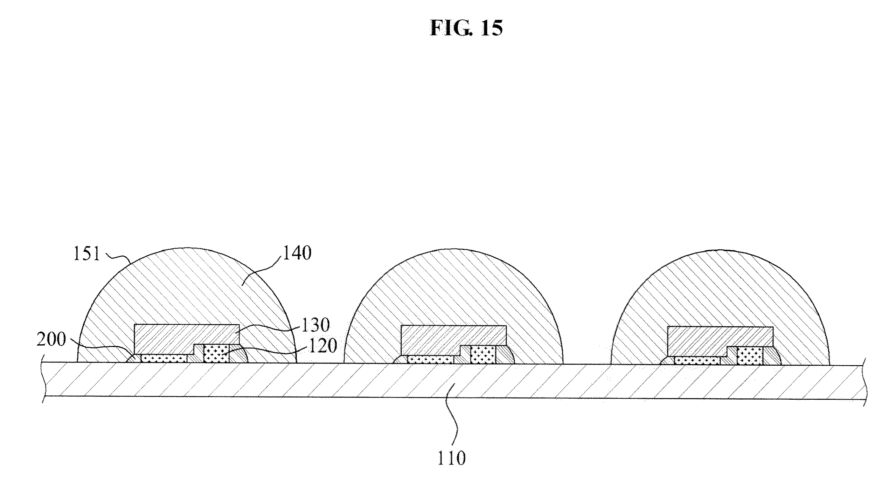

A configuration in which a phosphor layer and a lens unit are concurrently formed will be described with reference to FIG 15. Although, the configurations may be different from the aforementioned LED module, for ease of description, descriptions of structures that are similar to, or the same as the structures described in the foregoing will be omitted, for conciseness, or will be provided as needed.

An LED 130 may be mounted on a substrate 110 in a flip chip bonding scheme using a bump 120. Since the substrate 110 and the bump 120 are manufactured using a material having an excellent heat radiation characteristic, a heat radiation characteristic of an LED module may be enhanced.

Here, in order to implement white light, a phosphor layer may not be separately formed and a lens unit 150 having a phosphor material may be formed. That is, a phosphor layer surrounding the LED 130 may not be formed, and the lens unit 150 including the phosphor material and silicon in mixture may be formed. Thus, the lens unit 150 including the phosphor material may function as a wavelength conversion layer for implementing white light.

Accordingly, a manufacturing process may be simplified by forming the lens unit 150 including a phosphor material instead of forming the phosphor layer separately. As described in the foregoing, when a plurality of lens units and shapes of the plurality of lens units are different from each other, light extraction efficiency to an external environment may be enhanced, and an LED module suitable for various applications may be manufactured.

An LED module, according to an aspect of an embodiment may directly mount an LED and a lens unit on a substrate, thereby miniaturizing the LED module and obtaining a competitive price. A heat radiation characteristic may be enhanced through use of a metallic material as a substrate and a bump, and color uniformity may be enhanced due to various shapes of lens units.

Hereinafter, a method of manufacturing an LED module according to an aspect of an embodiment will be described, and for ease of description, features of manufacturing an LED module that are similar to, or the same as the structures described in the foregoing will be omitted, for conciseness, or will be provided as needed.

Here, the method of manufacturing an LED module according to an aspect of an embodiment may include: directly mounting an LED 130 on a substrate 110 using a bump 120, forming a phosphor layer 140 to surround the LED 130, and directly forming a lens unit 150 surrounding the phosphor layer 140 on the substrate 110.

The LED 130 may be directly mounted on the substrate 110 using various schemes. In this instance, the bump 120 may be disposed between the LED 130 and the substrate 110. Here, a conductive adhesive and the like may be used to directly mount the LED 130 on the substrate 110.

According to an aspect of an embodiment, when the LED module is manufactured in a COB scheme, wire bonding may not be used to form an electrical connection between an LED and a module substrate, and an FCOM scheme may be used to mount the LED on the module substrate in a flip chip form. Accordingly, when the LED is mounted on the FCOM, the LED may be mounted in a flip chip form and thus, LEDs may be densely mounted on the module substrate, thereby decreasing a module size.

Thereafter, the phosphor laver 140 may be formed to surround the LED 130. That is, the phosphor layer 140 may be formed to surround the entire LED 130 and be formed to be thin and uniform. By forming the phosphor layer 140 to be thin and uniform, a phosphor distribution around the LED 130 may be uniform, and light emitted from the LED 130 may be uniformly color converted.

After forming the phosphor layer 140, the lens unit 150 may be formed. When there is a plurality of lens units, shapes of the plurality of lens units may be the same or be different from each other. Hereinafter, an operation of directly forming the lens unit 150 on the substrate 110 will be further described.

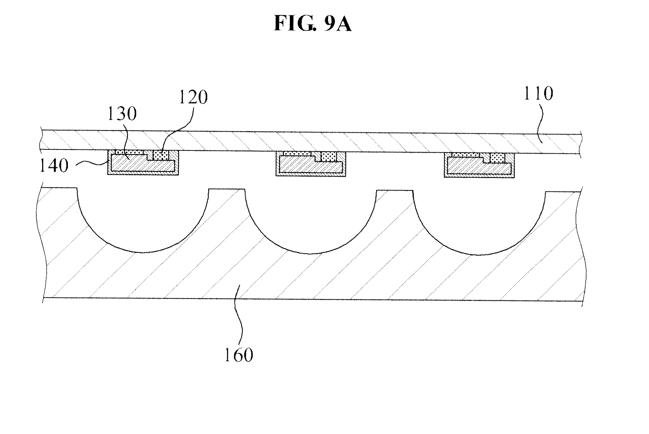

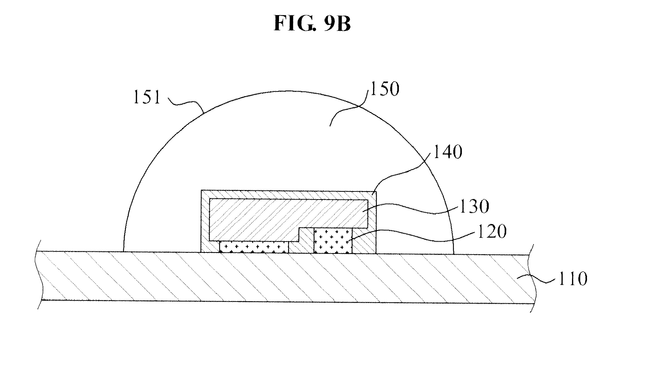

FIG. 9A and FIG. 9B are diagrams illustrating an example of manufacturing an LED module according to still another embodiment.

According to an aspect, the operation of directly forming the lens unit 150 on the substrate 110 may correspond to an injection molding scheme using a mold 160 as illustrated in FIG. 9A and FIG. 9B. The mold 160 may be disposed on the substrate 110 where the LED 130 and the phosphor layer 140 are formed. Thereafter, a lens molding compound may be injected in the mold 160, and a first thermal curing treatment may be performed according to the lens molding compound. Thereafter, the mold 160 may be separated, and a second thermal curing treatment may be performed according to the lens molding compound undergoing the first thermal curing treatment, thereby forming the lens unit 150.

According to an aspect, the operation of directly forming the lens unit 150 on the substrate 110 may correspond to a compression molding scheme using a mold. The compression molding scheme may be similar to the injection molding scheme in that a mold is used. However, the compression molding scheme may be partially different from the injection molding scheme in that pressure and heat are applied to press the mold, and be different from the injection molding scheme in that, the lens molding compound applied to an electric connection point is removed when an electric connection of the LED module is required since the lens molding compound is applied onto the entire substrate. The operation may be as follows. A mold is disposed on the substrate where the LED and the phosphor layer are formed. Thereafter, a lens molding compound is injected on an upper surface of the substrate and on an entire surface of the mold, and a first thermal curing treatment is performed according to the lens molding compound. Thereafter, the mold is separated, a second thermal curing treatment is performed according to the lens molding compound undergoing the first thermal curing treatment, and a portion of the lens molding compound applied to an electric connection point on the substrate is removed, thereby forming the lens unit.

In a scheme of forming the lens unit using a mold, a shape of the lens unit may vary depending on various applications, and lens units having different shapes may be combined regularly or irregularly.

The first thermal curing treatment may vary depending on a manufacturing process, and the second thermal curing treatment may be performed for about an hour at a temperature in the range of 150°C to 200 °C.

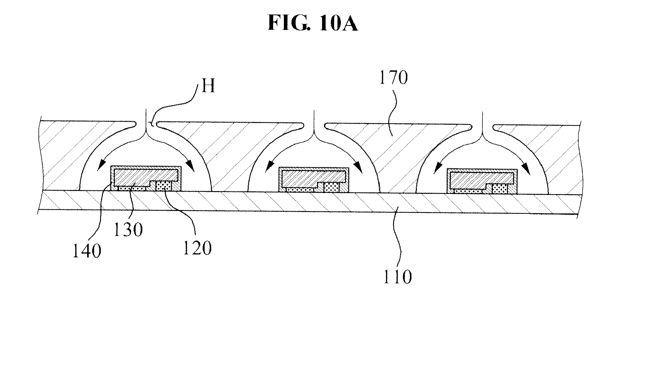

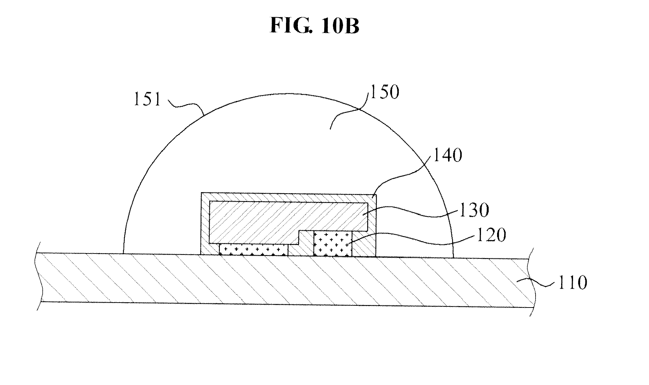

FIG. 10A and FIG. 10B are diagrams illustrating an example of manufacturing an LED module according to yet another embodiment.

According to an aspect of an embodiment, the operation of directly forming the lens unit 150 on the substrate 110 may correspond to a screen printing scheme as illustrated in FIG 10A and FIG. 10B. The operation may be as follows. A mask 170 including a hole pattern H may be disposed on the substrate 110 where the LED 130 and the phosphor layer 140 are formed. Thereafter, a lens molding compound may be screen printed in the hole pattern H. That is, the lens molding compound may be injected through the hole pattern H. Thereafter, the mask 170 may be separated from the substrate 110, and a thermal curing treatment may be performed with respect to the lens molding compound, thereby forming the lens unit 150.

In this instance, the screen printing of the lens molding compound may be performed in a vacuum state to reduce an occurrence of void in the lens unit 150.

In a scheme of forming the lens unit using the screen printing scheme, a shape of the lens unit may vary depending on various applications, and sizes of different hole patterns and thicknesses of masks may be combined regularly or irregularly. That is, a diameter of the lens unit may be associated with a size of a hole pattern. When a size of a hole pattern is relatively large, a diameter of the lens unit may be relatively long. When a size of a hole pattern is relatively small, a diameter of the lens unit may be relatively short. A height of the lens unit may be associated with a thickness of a mask. When a thickness of a mask is relatively thick, a height of the lens unit may be relatively high. When a thickness of a mask is relatively thin, a height of the lens unit may be relatively short.

According to an aspect of an embodiment, the operation of directly forming the lens unit on the substrate may correspond to a dispensing scheme using a dam. The operation may be as follows. A material for a dam may be dispensed around the LED on the substrate, or a dam may be formed in advance using a photoimageable solder resist (PSR) mask ink coating when the substrate is manufactured. Thereafter, a lens molding compound may be dispensed in the dam, and a thermal curing treatment may be performed according to the lens molding compound, thereby forming the lens unit.

In a scheme of forming the lens unit through the dispensing scheme that uses a dam, a shape of the lens unit may vary depending on various applications, and lens units of different shapes may be combined regularly or irregularly. In this instance, a height from a central point of the LED to an outer circumference of the lens unit may be determined through a control of an amount of the lens molding compound dispensed in the dam.

According to an aspect of an embodiment, the operation of directly forming the lens unit on the substrate may correspond to a scheme of forming the lens unit in advance and directly attaching the lens unit on the substrate where the LED is mounted using an adhesive. The operation may be as follows. After the lens unit is prepared using a molding, an adhesive may be applied onto the substrate. Thereafter, the prepared lens unit may be attached, and a thermal curing treatment may be performed with respect to the lens unit.

A shape of the lens unit may be formed in advance according to various applications, and lens units of different shapes that are formed in advance may be combined regularly or irregularly and subsequently disposed.

As described in the foregoing, a scheme of forming the lens unit may be various and may not be limited to the aforementioned schemes.

Accordingly, in a method of manufacturing an LED module according to an aspect of an embodiment, an operation may be minimized and simplified by directly mounting LEDs and a plurality of lens units having various shapes, and collectively forming the plurality of lens units. As such, price competitiveness may be enhanced by lowering a fraction defective and increasing yield of the LED module.

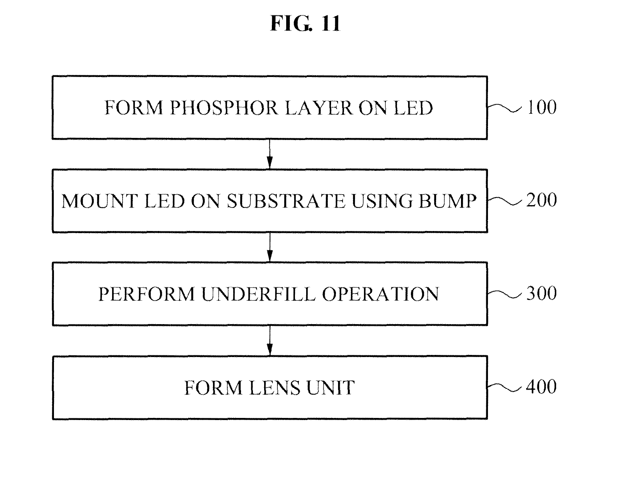

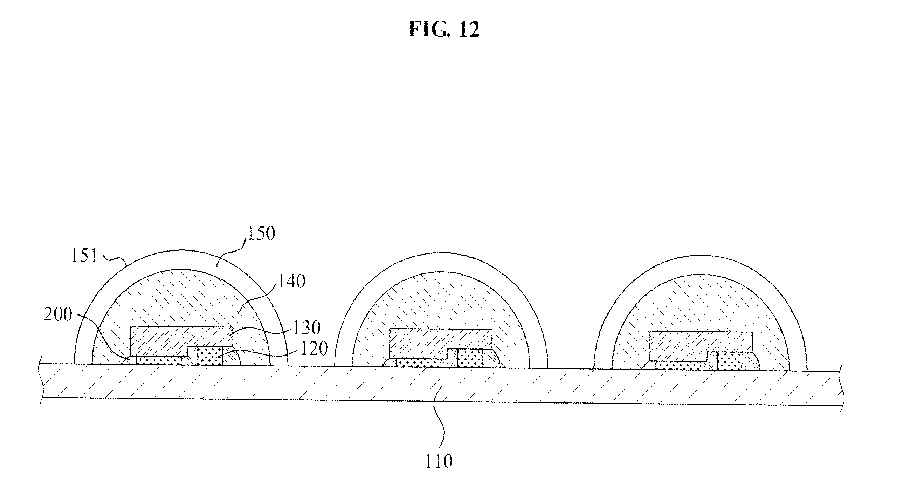

FIG. 11 illustrates an example of a method of manufacturing an LED module. FIGS. 12 through 15 illustrate examples of manufactured LED modules.

Referring to FIG. 11, a method of manufacturing an LED module according to an aspect of an embodiment may include operation 100 of forming a phosphor layer on an LED, operation 200 of mounting the LED on a substrate using a bump, operation 300 of performing an underfill operation, and operation 400 of forming a lens unit.

Hereinafter, a method of manufacturing an LED module according to an aspect of an embodiment will be described, and for ease of description, features of manufacturing an LED module that are similar to, or the same as the structures described in the foregoing will be omitted, for conciseness, or will be provided as needed.

In the method of manufacturing an LED module according to an aspect of an embodiment, an LED may be mounted on a substrate after a phosphor layer is initially formed on the LED, and the phosphor layer may be formed to surround the LED after the LED is mounted on the substrate.

As an example, after at least one LED surrounded by a phosphor layer is directly mounted on a substrate through a flip chip bonding using a bump, a lens unit surrounding the phosphor layer may be directly formed on the substrate, As another example, after the LED is mounted on the substrate, the phosphor layer may be formed, and then the lens unit may be formed to surround the phosphor layer.

In the LED mounted on the substrate using a flip chip scheme, an underfill operation may be used to enhance a reliability of a solder or bump connecting the LED and the substrate. In an operation of reflowing the bump, a crack may occur in the bump due to a difference in thermal expansion coefficients between the LED and the substrate, and the underfill operation may be used to prevent the occurrence of a crack. Here, reliability of the LED module may be enhanced due to the underfill operation.

A filler used for the underfill operation may have a relatively small thermal expansion coefficient and a relatively high thermal stability. In the method of manufacturing an LED module according to an aspect of an embodiment, an epoxy or a modified epoxy may be employed as the filler used for the underfill operation. When a separate underfill operation is omitted, a phosphor material or a lens molding compound may be employed as the filler.

The underfill operation may be performed using capillary action. That is, in the underfill operation, a filler corresponding to an underfill material may be dropped around the LED that is mounted using a flip chip scheme, and the underfill material may permeate due to capillary force. In this instance, an amine-based material may be used for curing of the filler corresponding to an underfill material,

The underfill operation may be performed in a fluxing underfill adhesion scheme using an immobilized material. In the underfill operation, the immobilized material may be discharged on a substrate before an LED is mounted using a flip chip scheme, and the LED may be mounted. In this instance, an anhydride-based material or a carboxylic ester-based material may be used for curing of a filler corresponding to the underfill material.

The underfill operation may be performed by a wafer level scheme using a thermoplastic polymer pre-form before attaching a flip chip. The wafer level scheme may be excellent in mass production since the underfill operation may be performed directly on a wafer. The preform used for the wafer level scheme may correspond to a nonconductive thermoplastic polymer, and correspond to an anisotropic film adhesive that is conductive in the z-direction.

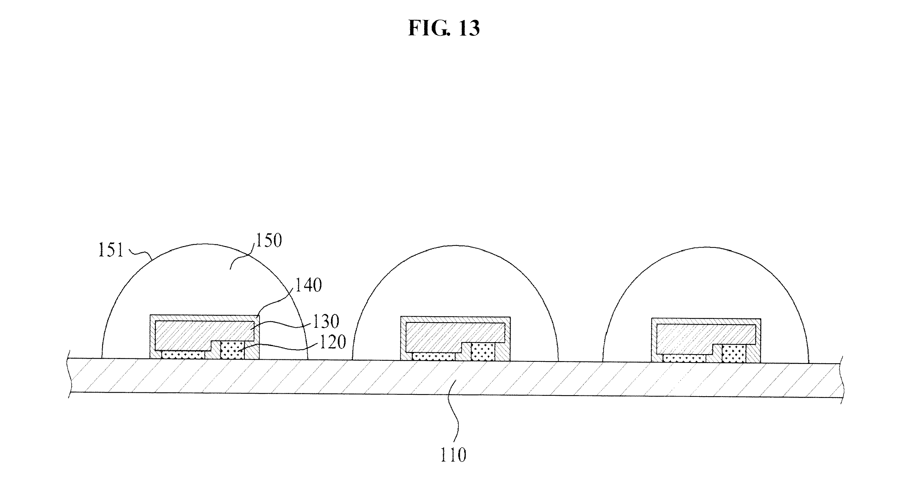

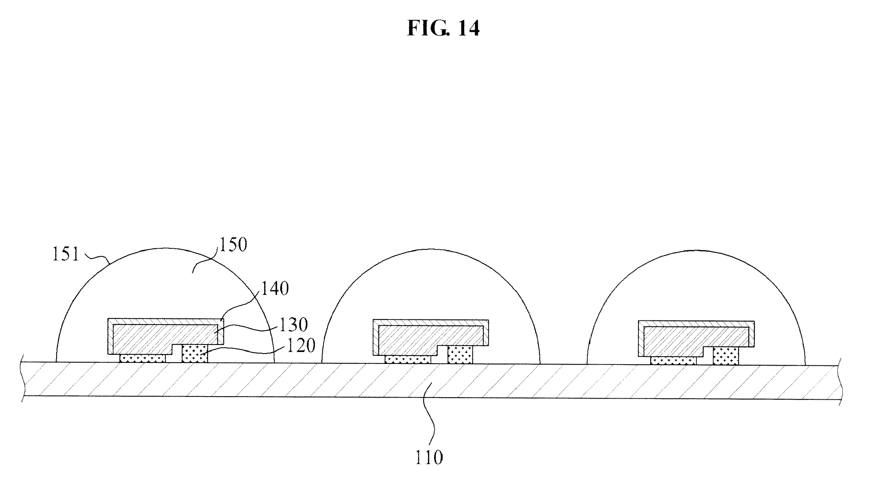

The underfill operation according to an aspect may be performed by injecting a separate filler 200 between a substrate 110 and an LED 130 as illustrated in FIG. 12 and FIG 15, by injecting a phosphor material during a formation of a phosphor layer 140 as illustrated in FIG. 13, or by injecting a lens molding compound during a formation of a lens unit 150 as illustrated in FIG. 14.

A method of manufacturing an LED module according to an aspect may include directly mounting at least one LED 130 on a substrate 110 by a flip chip bonding using a bump 120, and directly forming a lens unit 150, surrounding the LED 130 and including a phosphor material on the substrate 110.

In order to implement white light, the lens unit 150 including a phosphor material may be formed instead of forming a phosphor layer separately. That is, a phosphor layer surrounding the LED 130 may not be formed, and the lens unit 150 in which a phosphor layer and silicon are mixed may be formed. Thus, the lens unit 150 including a phosphor material may function as a wavelength conversion layer for implementing white light. Accordingly, a manufacturing process may be simplified by forming the lens unit 150 including a phosphor material instead of forming the phosphor layer separately.

In a method of manufacturing an LED module according to an aspect of an embodiment, a manufacturing process may be minimized and simplified by directly mounting an LED and a lens unit on a substrate and performing an operation in a wafer level.

An LED module according to an aspect of an embodiment may be applied to various applications by directly mounting an LED on a substrate, and by directly mounting lens units having various shapes on the substrate. The LED module may be miniaturized by directly mounting an LED and a lens unit on a substrate, and price competitiveness may be enhanced by lowering a fraction defective and increasing yield of the LED module. A heat radiation characteristic may be enhanced through use of a metallic material as a substrate and a bump.

Further, by employing lens units having various shapes, a desired orientation angle may be obtained and uniformity in luminance and color may be enhanced due to different levels of light extraction from the lens units.

In a method of manufacturing an LED module according to an aspect of an embodiment, an operation may be minimized and simplified by directly mounting LEDs and a plurality of lens units having various shapes on a substrate, collectively forming the plurality of lens units, and by performing the operation in a wafer level.

A number of examples have been described above. Nevertheless, it should be understood that various modifications may be made. For example, suitable results may be achieved if the described techniques are performed in a different order and/or if components in a described system, architecture, device, or circuit are combined in a different manner and/or replaced or supplemented by other components or their equivalents. Accordingly, other implementations are within the scope of the following claims.

## Claims

1. A light emitting device (LED) module, comprising:
a substrate;
an LED mounted on the substrate using a bump;
a phosphor layer surrounding the LED; and
a lens unit directly formed on the substrate and surrounding the phosphor layer.

2. The LED module of claim 1, wherein:
there are a plurality of the LEDs, a plurality of the phosphor layers, and a plurality of the lens units, and
the plurality of the lens units are of the same shape.

3. The LED module of claim 1, wherein:
there are a plurality of the LEDs, a plurality of the phosphor layers, and a plurality of the lens units, and
the plurality of the lens units are in different shapes.

4. The LED module of claim 1, wherein the LED is mounted on the substrate in a flip chip bonding or die bonding scheme.

5. The LED module of claim 1, wherein a shape of the lens unit corresponds to at least one of a batwing shape having a concave central portion, a shape in which a height from a central portion of the LED to an outer circumference of the lens unit is greater than a radius from the central portion of the LED to the outer circumference of the lens unit, and a shape in which a radius from the central portion of the LED to the outer circumference of the lens unit is greater than a height from the central portion of the LED to the outer circumference of the lens unit.

6. The LED module of claim 1, wherein the substrate and the bump include a metallic material.

7. A method of manufacturing a light emitting device (LED) module, the method comprising:
directly mounting an LED on a substrate using a bump;
forming a phosphor layer to surround the LED; and
directly forming a lens unit surrounding the phosphor layer on the substrate.

8. The method of claim 7, wherein the LED is directly mounted on the substrate in a flip chip bonding or die bonding scheme.

9. The method of claim 7, wherein:
there are a plurality of the LEDs, a plurality of the phosphor layers, and a plurality of the lens units, and
the plurality of the lens units are formed to be the same shape.

10. The method of claim 7, wherein:
there are a plurality of the LEDs, a plurality of the phosphor layers, and a plurality of the lens units, and
the plurality of the lens units are formed to be different shapes.

11. The method of claim 7, wherein the directly forming comprises:
disposing a mold on the substrate where the LED and the phosphor layer are formed;
injecting a lens molding compound into the mold;
performing a first thermal curing treatment according to the lens molding compound;
separating the mold; and
performing a second thermal curing treatment according to the lens molding compound undergoing the first thermal curing treatment, thereby forming the lens unit.

12. The method of claim 7, wherein the directly forming comprises:
disposing a mold on the substrate where the LED and the phosphor layer are formed;
injecting a lens molding compound on an upper surface of the substrate and on an entire surface of the mold;
performing a first thermal curing treatment according to the lens molding compound;
separating the mold;
performing a second thermal curing treatment with respect to the lens molding compound undergoing the first thermal curing treatment; and
removing a portion of the lens molding compound applied to an electric connection point on the substrate, thereby forming the lens unit.

13. The method of claim 7, wherein the directly forming comprises:
disposing a mask including a hole pattern on the substrate where the LED and the phosphor layer are formed;
screen printing a lens molding compound in the hole pattern;
separating the mask from the substrate; and
performing a thermal curing treatment according to the lens molding compound, thereby forming the lens unit.

14. The method of claim 7, wherein the directly forming comprises:
forming a dam around the LED on the substrate;
dispensing a lens molding compound in the dam; and
performing a thermal curing treatment according to the lens molding compound, thereby forming the lens unit.

15. The method of claim 7, wherein the directly forming comprises:
preparing the lens unit using a molding;
applying an adhesive onto the substrate to attach the prepared lens unit; and
performing a thermal curing treatment according to the attached lens unit.
